# EUROPÄISCHE PATENTSCHRIFT

(11) **EP 1 810 405 B1**
(45) Veröffentlichungstag und Bekanntmachung des Hinweises auf die Patenterteilung: **26.12.2012**
(21) Anmeldenummer: 05808297.5
(22) Anmeldetag: 08.11.2005
(51) Int. Cl.: H03K 17/94, G06F 3/023, G01B 11/02, H03K 17/96

(54) **Anordnung mit einer Arbeitsplatte und einem in der Arbeitsplatte angeordneten Glaskeramik-Kochfeld**
Arrangement with a worktop and a glass-ceramic hob arranged in the worktop
Arrangement comprenant un plan de travail et une plaque en vitrocéramique arrangée dedans

(30) Priorität: 08.11.2004 DE 102004055376
(43) Veröffentlichungstag der Anmeldung: 25.07.2007
(73) Patentinhaber: E.G.O. ELEKTRO-GERÄTEBAU GmbH, 75038 Oberderdingen (DE)
(72) Erfinder: BAIER, Martin, 76275 Ettlingen (DE)
(74) Vertreter: Patentanwälte Ruff, Wilhelm, Beier, Dauster & Partner
(86) Internationale Anmeldenummer: PCT/EP2005/011900
(87) Internationale Veröffentlichungsnummer: WO 2006/048325

(56) Entgegenhaltungen:
- EP-A- 0 779 712
- EP-A- 1 158 838
- DE-A1- 10 120 937
- DE-A1- 19 811 372
- DE-U1- 29 824 962
- FR-A- 2 693 859

## Beschreibung

Die Erfindung betrifft eine Anordnung gemäß dem Oberbegriff des Anspruchs 1.

Es sind sogenannte optische Berührschalter für Glaskeramik-Kochfelder bekannt, beispielsweise aus der DE 197 00 836 C1, welche nach dem Prinzip einer Reflex-Lichtschranke arbeiten. Unter einer lichtdurchlässigen Glaskeramikplatte befindet sich eine solche Reflex-Lichtschranke mit einem Sender und einem Empfänger. Wird ein Finger darüber auf die Glaskeramikplatte gelegt, so wird Licht von dem Sender zu dem Empfänger reflektiert, was als Bedienung ausgewertet werden kann. Dieses hat sich als vorteilhafte Methode bewährt, allerdings nur bei Abdeckungen, welche die entsprechende Lichtdurchlässigkeit oder Öffnung aufweisen. Nachteilig hierbei ist jedoch, dass aufgrund der Anordnung pro Lichtschranke jeweils nur maximal ein Berührschalter realisiert werden kann. Dies bedeutet einen relativ hohen Aufwand, insbesondere dann, wenn für bestimmte Steuerungen, beispielsweise für Spülmaschinen oder Kochfelder, eine größere Anzahl von Berührschaltern benötigt wird.

Des weiteren ist es nachteilig, dass sich die Berührfläche für den Finger auf dem Kochfeld befindet. Damit verbraucht sie Platz, der unter Umständen anderweitig gebraucht werden könnte. Es bestehen auch teilweise Hemmungen, den Finger auf das Kochfeld zu legen, selbst wenn es an einer kühlen Stelle ist.

Die EP 1 158 838 A zeigt eine Bedieneinrichtung für ein Elektrogerät, die eine große Bedienfläche aufweist. Unter der Bedienfläche sind in den Eckbereichen Sensoren angeordnet, mit denen es möglich ist, eine Berührung mit dem Finger an einer beliebigen Stelle zu erfassen und als Betätigung auszuwerten. Diese Sensoren können kapazitiv oder auch optisch arbeiten.

Die EP 779 712 A zeigt eine Bedieneinrichtung für ein Kochfeld mit einer Reflex-Lichtschranke unter einem Bedien-Feld. Ein Strahlenweg wird durch Auflegen eines Fingers von einem Sender zu einem Empfänger reflektiert, so dass dadurch das Auflegen des Fingers erkannt werden kann. Die FR 2 693 859 A zeigt eine ähnliche Bedieneinrichtung, wobei hier der Strahlenweg durch Lichtleiter exakt geführt wird.

Die DE 10120937 A zeigt allgemein einen Optosensor, der auf der Basis eines von einem Sender zu einem Empfänger reflektierten Strahlenweges arbeitet.

### Aufgabe und Lösung

Der Erfindung liegt die Aufgabe zugrunde, eine eingangs genannte Anordnung zu schaffen, mit der die Probleme des Standes der Technik vermieden werden können und insbesondere mit einer optischen Messeinrichtung bzw. einer Reflex-Lichtschranke mehrere Bedien-Felder angesteuert und ausgewertet werden können.

Gelöst wird diese Aufgabe durch eine Anordnung mit den Merkmalen des Anspruchs 1. Vorteilhafte sowie bevorzugte Ausgestaltungen der Erfindung sind Gegenstand der weiteren Ansprüche und werden im folgenden näher erläutert.

Bei einer Anordnung, deren Bedieneinrichtung als eine Art Reflex-Lichtschranke oder als Triangulations-Messeinrichtung eine optische Messeinrichtung mit optischer Entfernungsmessung und Sender und Empfänger über einen reflektierten Lichtstrahlenweg aufweist, kann ein Abstand eines Fingers oder dergleichen, welchen eine Bedienperson zum Bedienen auf das Bedien-Feld legt, zu der Messeinrichtung ermittelt werden. Dabei können der optischen Messeinrichtung mehrere Bedien-Felder zugeordnet werden, die in einer Linie liegen, insbesondere auf einer Geraden. Die Messeinrichtung kann jeweils den Abstand zu einem Bedien-Feld ermitteln bzw. den Abstand zu einer daran stattfindenden Bedienung, beispielsweise durch Auflegen eines Fingers auf das Bedien-Feld. Anstelle einer optischen Messeinrichtung kann genauso gut eine Messung mit Schall, insbesondere Ultra-Schall, zum Einsatz kommen. Im folgenden wird deswegen im wesentlichen von einer Messeinrichtung gesprochen, worunter auch eine mit akustischer Entfernungsmessung zu verstehen ist.

So ist es einerseits möglich, mit einer einzigen optischen oder akustischen Messeinrichtung möglicherweise mehrere Bedien-Felder bzw. eine daran stattfindende Bedienung auszuwerten. In diesem Fall weist die Linie der Bedien-Felder auf die Messeinrichtung. Über die Messung der Entfernung kann bei bekanntem Weg zu jeweils einem Bedien-Feld ermittelt werden, auf welchem Bedien-Feld eine Betätigung stattfindet. So kann der Aufwand für eine Auswertung mehrerer Bedien-Felder reduziert werden, da nur eine einzige optische Messeinrichtung bzw. Reflex-Lichtschranke benötigt wird. Vorteilhaft ist die Linie eben eine Gerade.

In weiterer Ausgestaltung der Erfindung kann vorgesehen sein, dass auf der Linie bzw. Geraden mit mehreren Bedien-Feldern eine zweite Messeinrichtung derselben Art liegt. Die Bedien-Felder befinden sich dabei zwischen den Messeinrichtungen. Auf diese Art und Weise kann mit den

Messeinrichtungen nicht nur der Abstand der Bedienung eines Bedien-Feldes zu einer Messeinrichtung ermittelt werden, was beispielsweise bei einem sehr breiten Bedienungsgegensta nd, wie mehreren Fingern, anstatt nur eines Fingers und somit in der Regel mehrerer Bedien-Felder, eine sicherere Auswertung ermöglicht. Wird nämlich im Rahmen eines Verfahrens sozusagen von beiden Seiten der Ort der Bedienung eines Bedien-Feldes ermittelt, so kann auch die Breite des Fingers oder des Bedienungsgegenstandes ermittelt werden. Falls also der Finger über mehreren Bedien-Feldern ist, liegt eine Fehlbedienung vor, was die Bedieneinrichtung somit als solche erkennen kann und beispielsweise eine entsprechende Fehlermeldung an den Bediener ausgeben kann.

Bei einer alternativen Ausführung ist es mögl ich, dass die Linie der Bedien-Felder einen Abstand zu der Messeineinrichtung aufweist und somit daran vorbeiläuft. In weiterer vorteilhafter Ausgestaltung ist es vorgesehen, dass mehrere Messeinrichtungen nebeneinander angeordnet sind und die Linie mit gleichem Abstand bzw. parallel dazu verläuft. Bevorzugt sind dabei ebenso viele Messeinrichtungen wie Bedien-Felder vorgesehen.

Besonders bevorzugt ist zu der ersten Linie von Bedien-Feldern eine zweite parallele Linie von weiteren Bedien-Feldern vorgesehen. Somit kann also eine Bedieneinrichtung geschaffen werden, bei der mehrere Messeinrichtungen nebeneinander angeordnet sind. Eine Fläche von Bedien-Feldern ist so aufgeteilt, dass vor den Messeinrichtungen bzw. vor jeder Messeinrichtung mehrere Bedien-Felder liegen in einer Richtung von der Messeinrichtung weg. Gleichzeitig können diese Bedien-Felder in Linien verlaufen, welche parallel zu der Linie der Messeinrichtungen liegt. Wichtig ist dabei der Aspekt, dass es möglich ist, mehrere Bedien-Felder einer einzigen Messeinrichtung zuzuordnen. Über die Entfernungsmessung kann wiederum bestimmt werden, welches der Bedien-Felder bedient wird bzw. auf welchem beispielsweise ein Finger aufgelegt ist zur Bedienung.

Es kann vorgesehen sein, dass der Weg der Reflex-Lichtstrahlen parallel zur Fläche der Bedien-Felder verläuft. So ist es vorteilhaft möglich, dass die Messeinrichtungen nicht unterhalb der Fläche vorgesehen sein müssen, auf welcher die Bedien-Felder liegen. Dies ermöglicht es beispielsweise, die Bedien-Felder auf optisch nicht durchlässi gen Flächen anzuordnen, beispielsweise metallischer Art. Des weiteren kann durch diesen Abstand zwischen Messeinrichtungen und Bedien-Feldern eine Anordnung vorgesehen sein, bei welcher die Bedien-Felder nicht körperlich mit der Bedieneinrichtung selber als elektrisches Gerät oder Teil davon verbunden sein müssen. Dies wird nachfolgend noch genauer erläutert.

Des weiteren können Beleuchtungsmittel vorgesehen sein, welche ein Bedien-Feld für einen Bediener kennzeichnen. Dazu können sie das Bedien-Feld von außen beleuchten oder anstrahlen. Eine Kennzeichnung kann entweder nur durch Beleuchtung oder aber durch Projizieren oder Erzeugen gewisser Symbole erfolgen, welche auch verschiedene Farben aufweisen können. So kann jeweils eine unterschiedliche vorgesehene Funktion eines Bedien-Feldes angezeigt werden.

Bei der erfindungsgemäßen Anordnung ist vorgesehen , dass eine vorgenannte Bedieneinrichtung an einem Rand oder Rahmen zumindest teilweise vorgesehen ist. In weiterer Ausgestaltung der Erfindung ist diese Bedieneinrichtung jederzeit frei zugängtich angeordnet. Ein Rahmen des Glaskevanik - kochfeldes ist in einer umgebenen 30 Küchenarbeitsptatte angordret , auf welcher auch die Bedien-Felder vorgesehen sind. Mit einer vorgenannten Bedieneinrichtung im Rand oder am Rahmen des Kochfeldes sind die Bedien-Felder auf einer Fläche vorgesehen , welche nicht zum Kochfeld selber gehört. Dabei sind Sender und Empfänger der Messeinrichtungen innerhalb des Randes oder Rahmens angeordnet. Mittels Lichtleitern, Lichtumlenkmitteln oder dergleichen kann der reflektierte Lichtstrahlenweg nach außen zu den Bedien-Feldern hin und zurück geleitet werden. Dabei ist vorteilhaft eine Richtungsänderung des Strahlungsweges vorgesehen, was durch die Lichtleiter oder Lichtumlenkmittel möglich ist.

Auf diese Weise its ein Glaskeramik-Kochfeld, in einer Küchenarbeitsplatte angeordnet. Beispielsweise kann eine Linie von Bedien-Feldern parallel zu dem Rand oder Rahmen eines Kochfeldes verlaufen mit sehr geringem Abstand dazu, insbesondere wenige Zentimeter. Die Bedien-Felder können dauerhaft und sichtbar auf der Arbeitsplatte gekennzeichnet sein, beispielsweise durch Beschriftung, Aufdruckung, ebenso wie durch Einprägungen oder erhabene Stellen. Besonders vorteilhaft ist hier vorgesehen, dass mehrere Reihen von Bedien-Feldern vorgesehen sind. Auf diese Weise ist es vorteilhaft möglich, die benötigte Fläche für die Bedien-Felder nicht auf dem Kochfeld selber, sondern neben dem Rand vorzusehen. So ist es vorteilhaft möglich, bei gleichbleibender Größe des Kochfeldes größere oder mehr Kochstellenbeheizungen vorzusehen. Des weiteren können durch Variation der vorgesehenen Bedien-Felder ohne konstruktive Änderungen oder Änderungen an einer Kennzeichnung des Kochfeldes Bedieneinrichtungen mit weiteren Funktionen bzw. Bedien-Feldern versehen werden. Ein weiterer Vorteil liegt darin, dass bei einem Verlegen der Bedien-Felder weg von der Fläche des Kochfeldes ein psychologisches Hemmnis bei manchen Bedienern beseitigt werden kann, weil diese zur Bedienung nun nicht mehr auf das Kochfeld fassen müssen. Gleichzeitig kann jedoch weiterhin die Bedieneinrichtung in dem Kochfeld bzw. in dem Elektrogerät angeordnet werden, so dass der Einbauaufwand reduziert wird.

Alternativ zu einem solchen Elektrogerät in Form beispielsweise eines Kochfelds bzw. einer entsprechenden Anordnung ist es möglich, ein Elektrogerät mit einer bewegbaren Abdeckung oder Tür vorzusehen. In deren Rand ist die Bedieneinrichtung angeordnet, beispielsweise in einer Stirnseite oder einem Türfalz der Abdeckung bzw. Tür. Insbesondere bei Spülmaschinen ist dies eine vorteilhafte Gestaltung, da dort üblicherweise im Türfalz die Bedieneinrichtungen vorgesehen sind. Werden diese nun auf vorgenantem optischen Weg ausgestaltet, so sind mechanische Tasten sowie die zugehörigen Probleme mit Dichtheit und dergleichen vermeidbar.

Hier können beispielsweise zwei optische Messeinrichtungen im Rahmen oder im Türfalz einer Tür mit großem Abstand zueinander vorgesehen sein. Dazwischen können in einer Linie Bedien-Felder angeordnet sein, so dass Messeinrichtungen und Bedien-Felder sämtlich in einer Linie liegen. Sind die Messeinrichtungen beispielsweise an gegenüberliegenden Ecken oder Enden einer Seite der Tür oder Abdeckung vorgesehen, so ist der gesamte zwischenliegende Bereich für die Bedien-Felder nutzbar. Aus der sich daraus ergebenden Anzahl von Bedien-Feldern kann in der Regel eine ausreichende Bedienmöglichkeit geschaffen werden. Die Messeinrichtungen können in Vorsprüngen oder hervorstehenden Teilen angeordnet sein, welche von dem Rahmen wegragen bzw. sich über diesen erheben. Diese Erhebung kann wenige Zentimeter betragen, beispielsweise ca. drei Zentimeter.

Bei einem beispielhaften Verfahren kann eine Auswertung entweder für Bedien-Felder erfolgen, welche auf einer Linie liegen, auf der sich auch die entsprechenden Messeinrichtungen befinden. Hierbei wird, wie zuvor beschrieben, vorteilhaft von beiden Seiten der Abstand zu dem Ort der Bedienung gemessen. So kann dessen Breite bzw. räumliche Ausdehnung erfasst werden. Wenn diese mit der Breite und Position des möglichen zugehörigen Bedien-Feldes übereinstimmt, kann dessen Bedienung erkannt und als solche gewertet werden.

Bei einem Verfahren zum Betrieb einer Bedieneinrichtung, bei welcher mehrere Messeinrichtungen nebeneinander vorgesehen sind und die zugehörigen Bedien-Felder auf Linien von diesen weg liegen, insbesondere parallel zueinander, kann vorgesehen, dass die Sender abwechselnd Lichtstrahlen aussenden und die benachbarten Empfänger jeweils das ausgesandte Licht empfangen. Vorteilhaft werden die Sender im versetzten oder Multiplex-Betrieb angesteuert, so dass sie sich nicht gegenseitig stören. Besonders vorteilhaft sind jeweils einem Bedien-Feld bzw. einer Reihe von Bedien-Feldern genau ein Sender und ein Empfänger zugeordnet. Diese bilden die Messeinrichtung, welche ausschließlich die zugehörigen Bedien-Felder auswerten kann. Durch Messung der Entfernung zu einer Stelle der Bedienung bzw. der Reflektion der Lichtstrahlen kann bestimmt werden, welches der davor liegenden Bedien-Felder bedient wird.

Bei einer alternativen Ausgestaltung können vor jeder Reihe von Bedien-Feldern jeweils die Empfänger angeordnet sein. Die Sender können an grundsätzlich beliebiger Stelle, insbesondere jeweils zwischen den Bedien-Feldern, vorgesehen sein. Bei einem Auswerteverfahren kann ermittelt werden, an welchem Empfänger das zurückreflektierte Signal mit der größten Stärke vorliegt. Daraus kann jeweils ein betätigtes Bedien-Feld ermittelt werden.

Alternativ zu einem Multiplex-Betrieb können die Sender bei gleichzeitigem Betrieb kodierte Lichtsignale aussenden. Auch so ist es möglich, dass die Empfänger bei einem empfangenen reflektierten Lichtsignal ermitteln können, von welchem Sender diese stammen.

Bei einer einfachen Variante können durch geometrische Anordnung und evtl. Lichtführung bzw. Abdeckung genaue Zuordnungen zwischen Messeinrichtungen und Bedien-Feldern geschaffen werden. Diese machen eine fehlerhafte Auswertung unmöglich.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein können. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im folgenden näher erläutert. In den Zeichnungen zeigen: ,
- Fig. 1: einen seitlichen Schnitt durch eine erfindungsgemäße anordnung mit Bedieneinrichtung im Rahmen eines Kochfeldes in einer Arbeitsplatte,
- Fig. 2: eine Draufsicht auf die Bedieneinrichtung aus Fig. 1,
- Fig. 3: eine Seitenansicht einer Tür einer Geschirrspütmaschine, bei der im Türfalz eines beispielhafte Bedieneinrichtung installiert ist,
- Fig. 4: eine Draufsicht auf die Bedieneinrichtung aus Fig. 3,
- Fig. 5: eine Schrägansicht eines eingebauten Kochfeldes, in dessen vorderen Rahmen eine weitere, beispielhafte Bedieneinrichtung eingebaut ist und
- Fig. 6: eine alternative Ausbildung einer Anordnung zur Entfernungsmessung über Triangulation.

### Detaillierte Beschreibung der Ausführungsbeispiele

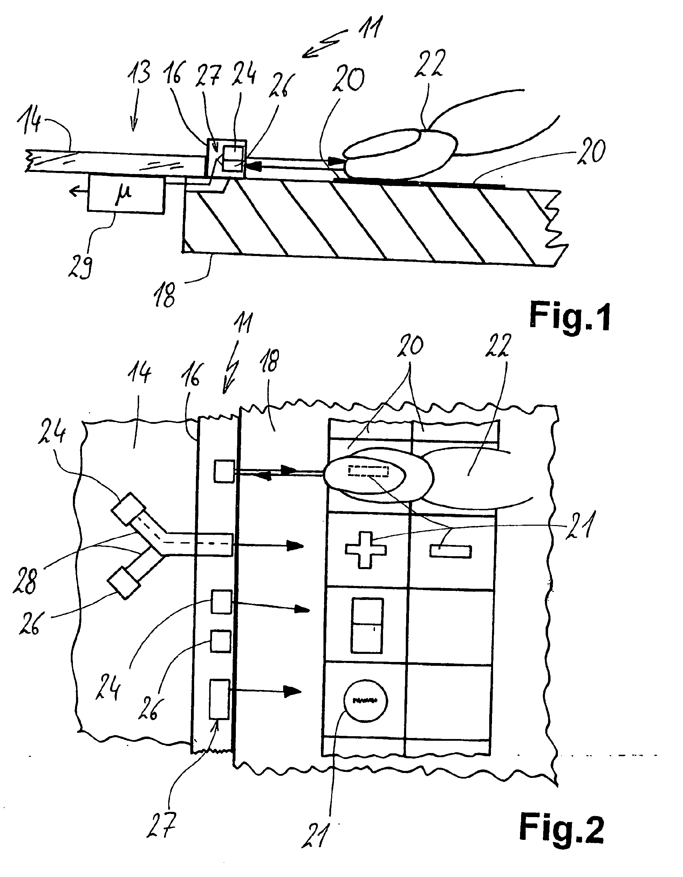

In Fig. 1 ist eine erfindungsgemäße Anordnung 11 dargestellt, bei welcher ein Glaskeramik-Kochfeld 13, bestehend aus Glaskeramikplatte 14 und Rahmen 16, in einen entsprechenden Ausschnitt einer Arbeitsplatte 18 eingesetzt ist. Auf der Arbeitsplatte 18 sind mehrere Bedien-Felder 20 angeordnet, und zwar mehrere Bedien-Felder 20 nebeneinander in einer Art Doppelreihe, wie aus Vergleich mit Fig. 2 hervorgeht. Ein Finger 22 ist beispielhaft auf eines der Bedien-Felder aufgelegt und soll dessen Betätigung darstellen.

Die Bedien-Felder 20 tragen beispielsweise auf ihrer Oberseite die Symbole 21, welche beispielsweise als Plus- oder Minus-Zeichen ausgebildet sein können. Solche aufgedruckten Symbole 21 werden als vorteilhaft angesehen, da sie samt der Bedien-Felder 20 auf die vorhandene Arbeitsplatte 18 lediglich aufgebracht werden müssen, beispielsweise durch Kleben, Bedrucken oder dergleichen. Die Funktion der Bedien-Felder 20 liegt hier lediglich darin, einen gewissen Ort anzugeben, auf welchen ein Finger 22 zur Betätigung gelegt werden soll. Weitere Funktionalitäten sind nicht unbedingt notwendig.

In dem Rahmen 16, welcher in etwa nach Art eines Gehäuses hohl ausgebildet ist, befinden sich Sender 24 und Empfänger 26, welche zusammengehören und eine Art Reflex-Lichtschranke 27 bilden. Sie können, wie aus den nachfolgenden Figuren auch hervorgeht, als eine Baueinheit oder alternativ als einzelne Bauteile ausgebildet sein. Sender 24 und Empfänger 26 bzw. die Reflex-Lichtschranke 27 sind mit einer Steuerung 29 signalübertragend verbunden, welche insbesondere unterhalb der Glaskeramikplatte 14 angeordnet ist. Diese Steuerung 29 kann auch für die sonstigen Funktionen des Glaskeramik-Kochfeldes 13 ausgebildet sein oder zumindest sämtliche bedienungsbezogenen Funktionen übernehmen. Die signalübertragende Verbindung kann einerseits per Kabel erfolgen, wie dargestellt ist. In diesem Fall ist unter Umständen ein Ausschnitt in der Arbeitsplatte 18 vorzusehen. Alternativ kann die Anordnung 11 bzw. der Einbau des Glaskeramik-Kochfeldes 13 in die Arbeitsplatte 18 derart sein, dass ein Abschnitt des Rahmens mit einer signalführenden Leitung oder Verbindung innerhalb des Ausschnitts in der Arbeitsplatte liegt. Des weiteren ist es möglich, eine signalübertragende Verbindung kabellos auszubilden bzw. per Funk oder Licht- bzw. IR-Verbindung.

Aus der Draufsicht in Fig. 2 ist zu erkennen, wie die Bedien-Felder 20 auf der Arbeitsplatte 18 eine Doppelreihe bilden. Hier können sogar noch mehr Reihen vorgesehen sein. Jedem Bedien-Feld 20 bzw. jeder Spalte von Bedien-Feldern 20 in Richtung von den Lichtschranken 27 weg ist jeweils genau eine Lichtschranke zugeordnet. Die Ausrichtung von Sendern 24 und Empfängern 26 bzw. der vorgesehene Lichtstrahlenweg ist derart, dass er entweder, wie bei der in Fig. 2 als oberste dargestellten Lichtschranke, sehr eng beieinander liegt durch beispielsweise übereinander angeordnete Sender und Empfänger. Somit spielt eine größere Entfernung eines Fingers 22 von der Lichtschranke 27 keine große Rolle. Bei den darunter dargestellten Anordnungen ist es so, dass Sender 24 und Empfänger 26 nebeneinander entweder einzeln oder in einem Modul vorgesehen sind. Dies ermöglicht unter anderem eine flachere Bauweise des Rahmens 16, was als vorteilhaft angesehen werden kann. Es sind jeweils Ausrichtung der Lichtstrahlen des Senders 24 und Empfangsmittel des Empfängers 26 auf die verschiedenen Winkel einzurichten, mit welchen das Licht ausgesandt sowie empfangen wird.

Des weiteren ist in Fig. 2 eine beispielhafte Variante dargestellt, bei welcher Sender 24 und Empfänger 26 nicht im Rahmen 16, sondern dahinter bzw. unter der Glaskeramikplatte 14 angeordnet sind. Mittels Lichtleitern 28 wird das Licht ebenso wie bei den sonstigen Sendern und Empfängern bis an den Rand des Rahmens 16 geführt bzw. dort eingefangen. Eine derartige Anordnung weist den Vorteil auf, dass die Bauteile von Sender und Empfänger nicht im Rahmen 16, sondern dahinter oder darunter angeordnet werden können, wo beispielsweise auch die sonstige Steuerung sitzt. Vor allem ist es so auch vorstellbar, die Höhe des Rahmens 16 noch geringer zu machen.

Des weiteren ist es möglich, dass ein Teil der Lichtschranken 27 zwar am Rahmen 16, aber mehr an dessen Unterseite bzw. darunter angeordnet ist. Somit greifen die Lichtschranken oder ihre Bestandteile teilweise in die Arbeitsplatte 18, welche entsprechende Aussparungen aufweisen sollte.

Der Rahmen 16 ist an bestimmten Stellen für die Lichtstrahlen entsprechend lichtdurchlässig ausgebildet, entweder mit Öffnungen oder mit Fenstern. Fenster haben vor allem den Vorteil, dass sie in einer abgedichteten Version verhindern, dass Flüssigkeit, welche insbesondere beim Kochen oder Putzen vorhanden ist, in das Innere des Kochfeldes 13 gelangen kann.

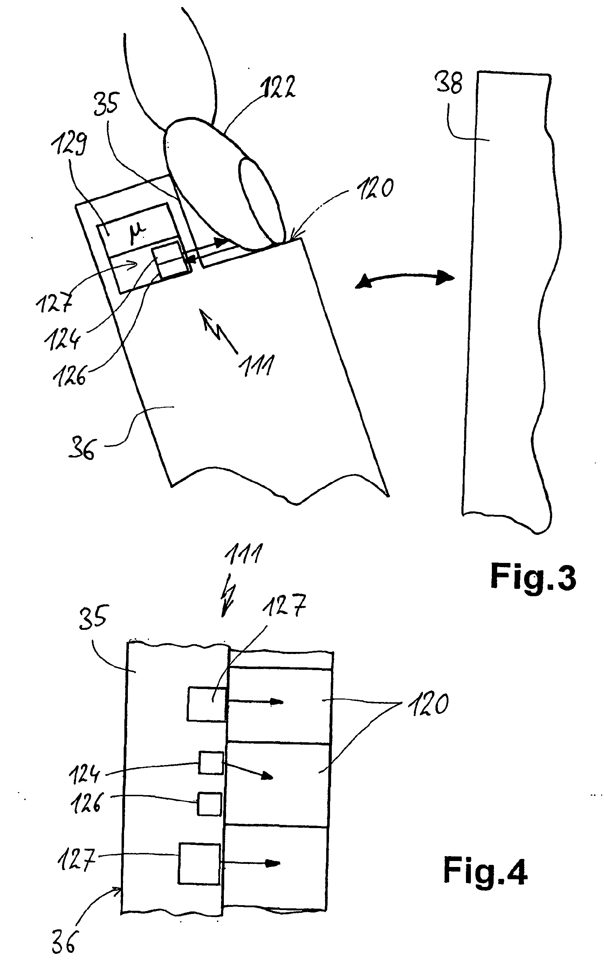

In Fig. 3 ist eine beispielhafte Anordnung 111 nach ähnlichem Prinzip, aber bei einem anderen Elektrogerät dargestellt. In den Türfalz 35 einer Tür 36 einer Geschirrspülmaschine 38 ist eine Bedieneinrichtung mit einer Reihe von nebeneinanderliegenden Bedien-Feldern 120 vorgesehen. In dem abstehenden Absatz des Türfalzes 35, welcher über die Bedien-Felder 120 übersteht, sind Reflex-Lichtschranken 127 bestehend aus Sendern 124 und Empfängern 126 angeordnet. Ebenso ist eine entsprechende Steuerung 129 vorgesehen, welche mit den Lichtschranken 127 verbunden ist. Die Anordnungen, insbesondere auch verschiedene Ausbildungen der Lichtschranken ähnlich Fig. 2, können aus Fig. 4 entnommen werden. Vorteilhaft muß nicht direkt die Fläche vor dem Sensor berührt werden, sondern es kann ein gewisser Abstand gegeben sein.

In dem Türfalz 35 sind wieder entsprechende lichtdurchlässige Bereiche, insbesondere mittels Fenstern, vorgesehen. Dies weist vor allem den Vorteil auf, dass bei einem Elektrogerät wie einem Geschirrspüler 38, das Problem mit Feuchtigkeit im Inneren bzw. an der Anordnung 111 der Bedieneinrichtung gegenüber sonstigen mechanischen Tasten, welche meistens Öffnungen benötigen, vermieden werden kann. Die meisten anderen Berührungsschalter auf beispielsweise kapazitiver Basis würden in einem solchen Anwendungsfall ebenfalls nicht praxistauglich arbeiten, da vor allem kapazitive Berührungsschalter durch Anwesenheit von Feuchtigkeit gestört werden.

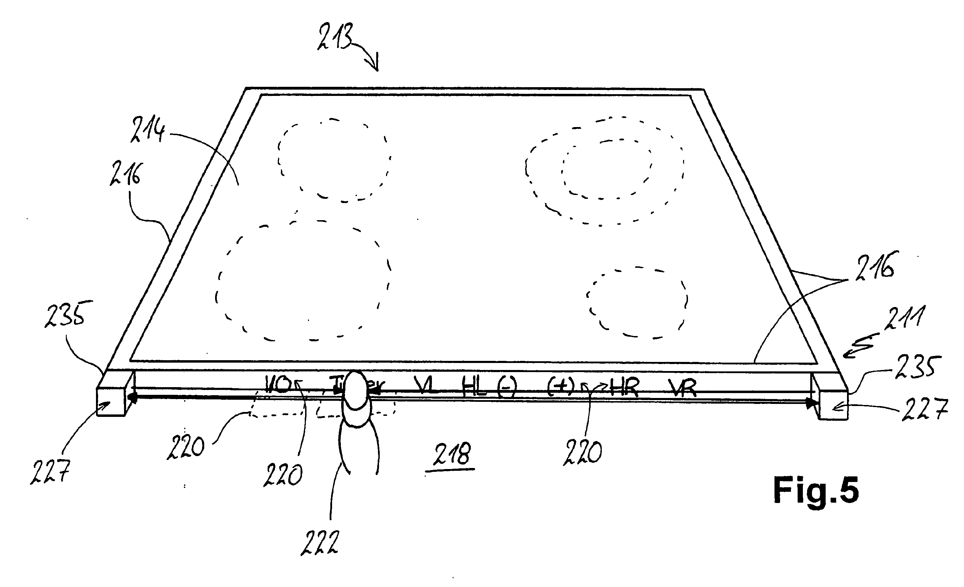

In Fig. 5 schließlich ist eine weitere beispielhalfte Anordung 211 dargestellt, welche wiederum ein Kochfeld 213 ist mit einer Glaskeramikplatte 214. Dabei ist der Rahmen 216 des Kochfelds 213 normal ausgeführt bzw. entspricht einem üblichen umlaufenden Rahmen. An der linken und rechten vorderen Ecke sind Vorsprünge 235 angeordnet, die über die Vorderseite bzw. den vorderen Teil des Rahmens 216 überstehen und beispielsweise auf einer Arbeitsplatte oder dergleichen aufliegen. An dieser Vorderseite des Rahmens 216 sind an mehreren Stellen Bedienfelder 220 vorgesehen, welche durch diverse Beschriftungen, wie beispielsweise I/O, Timer, VL oder HL etc., gekennzeichnet sind als Entsprechung der Symbole 21 gemäß Fig. 2. Das Auflegen eines Fingers 222 auf eines dieser Bedien-Felder 220 soll eine Bedienung darstellen bzw. auslösen. Die Bedien-Felder könnten auch anstelle am Rahmen 216 an den davor liegenden Bereichen der Arbeitsplatte 218 liegen, wie an der linken Seite durch die Strichlierung dargestellt ist.

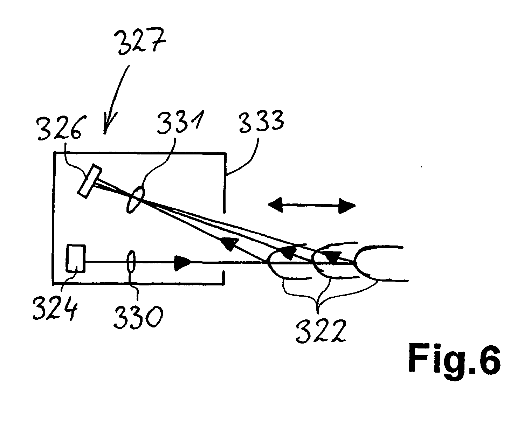

In den Vorsprüngen sind 235 optische Entfernungs-Messeinrichtungen 227 angeordnet, welche der Übersichtlichkeit halber hier nicht im einzelnen gezeichnet sind. Vorteilhaft arbeiten sie mit Laser-Triangulation, wie in Fig. 6 dargestellt. Das bedeutet, dass ein zu messendes Objekt mit einem Lichtstrahl schräg ängestrahlt wird, und in Abhängigkeit von seiner Entfernung zu der Anstrahlung wird das Licht in einem anderen Winkel reflektiert, und zwar auch schräg. Dieses reflektierte Licht wird von einem speziellen Empfänger, ggf. unter Vorschaltung einer Sammellinse, gebündelt und auf einen flächigen Lichtempfänger geworfen. In Abhängigkeit von dem Auftreffpunkt des reflektierten Lichtstrahls kann auf die WInkelverhältnisse und somit relativ genau auf die Entfernung des zu messendes Objekt geschlossen werden. Diese Methode ist an sich für den Fachmann einfach zu realisieren. Sie stellt eine gute Alternative zu der bereits vorgenannten Entfernungsmessung über Laufzeitmessung dar. In den Darstellungen der Figuren können beide Verfahren eingesetzt werden, ohne eine unbedingt zu bevorzugen. Von der Darstellung wird darauf jedoch nicht besonders abgehoben.

Somit können die Entfernungs-Messeinrichtungen gemäß einer der vorstehenden Abbildungen ausgebildet sein, beispielsweise wie in Fig. 1. Dies gilt auch für ihre signalübertragende Verbindung mit einer Steuerung des Kochfeldes 213 oder dergleichen.

Wie durch die Pfeile von den Sendern und die reflektierten Lichtwege dargestellt, kann durch Messung der Entfernung des Fingers 222 jeweils von dem linken Vorsprung 235 als auch von dem rechten Vorsprung 235 die genaue Position sowie auch die Breite des Fingers an den Bedien-Feldern 220 ermittelt werden. Daraus ist leicht zu bestimmen, auf welches Bedienfeld 220 der Finger 222 gelegt ist und somit welches Bedien-Feld ausgewählt wurde. Mit einer solchen Anordnung 211 gernäß Fig. 5 kann, anders als bei den vorherigen Anordnungen, nur eine einzige Reihe von Bedien-Feldern entlang einer Linie ausgewertet werden. Sollen bei diesem Prinzip mehrere nebeneinander liegende Reihen von Bedien-Feldern ausgewertet werden, so wären die Vorsprünge 235 etwas länger auszubilden und für jede Reihe jeweils zwei Lichtschranken vorzusehen. Des weiteren ist es möglich, die Bedien-Felder 220 nicht nur an der Vorderseite des Rahmens 216 darzustellen, sondern eventuell auch an den davor liegenden Bereichen der darunterliegenden Arbeitsplatte 218, wie gestrichelt dargestellt. Dies kann in etwa der Anordnung aus den Fig. 1 und 2 entsprechen. Die in Fig. 5 dargestellten Symbole 221 auf den Bedien-Feldern 220 können alternativ zu einer Bedruckung oder festgelegten Darstellung auch durch darunter liegende variable Anzeigen oder dergleichen verwirklicht sein. Auf diese Art und Weise kann beispielsweise eine Art kontextabhängige Bedieneinrichtung geschaffen werden.

Einer der Vorteile einer Anordnung beispielsweise gemäß Fig. 1 und 2 ist darin zu sehen, dass wegen des Auslagerns der Bedien-Felder 20 das Gerät bzw. das Kochfeld 13 insgesamt kleiner gestaltet werden kann oder mehr bzw. in der Praxis größere Kochstellen vorgesehen sein können. Des weiteren sind die Lichtschranken an sich für die Auswertung mehrerer Reihen von Bedien-Feldern ausgelegt. Entsprechende Funktionalitäten können nachträglich in der Regel über Softwareänderung an der Steuerung vorgenommen werden. Durch einen relativ leichten Austausch der Symbole 21 bzw. der Kennzeichnung der Bedien-Felder 20 kann somit ein Kochfeld 13 auch nachträglich erweitert bzw. aufgerüstet werden, ohne aufwendig in das Gerät selber eingreifen zu müssen oder bauliche Veränderungen vorzunehmen.

Fig. 6 zeigt eine Anordnung 327 nach dem Prinzip der Triangulation. Ein Sender 324, vorteilhaft ein Laserstrahler bzw. eine Laserdiode, sendet Licht aus, ggf. durch die vorgeschaltete Optik 330. Dieser Lichtstrahl trifft auf einen Finger 322. Von diesem wird er reflektiert und über eine Linse 331 auf den Empfänger 326 geworfen. Die Linse 331 dient dazu, auf dem Empfänger einen scharfen Lichtpunkt zu erzeugen. Es ist zu erkennen, wie je nach Entfernung des Fingers von der Anordnung 327 der Auftreffpunkt des Lichtstrahls auf dem Empfänger 326 seine Position ändert als Folge des unterschiedlichen Winkels zwischen ausgesandtem und reflektiertem Strahl. Diese seitliche Verschiebung des Lichtp unkts auf dem Empfänger 326 kann erkannt werden und als unterschiedliche Entfernung ausgewertet werden. Dabei ist eine erstaunliche Genauigkeit möglich.

Als Empfänger kann vorteilhaft ein PSD (Position Sensing Device) oder ein CCD (Charge Coupled Device) verwendet werden. Insbesondere können diese in Zeilenform aufgebaut sein, wodurch die seitliche Verschiebung des Lichtpunkts besonders gut und genau gemessen werden kann.

## Patentansprüche

1. Anordnung mit einer Arbeitsplatte und einem in der Arbeitsplatte angeordneten Glaskeramik-Kochfeld mit einem Rahmen (16, 216), wobei eine Bedieneinrichtung (20, 220) vorgesehen ist, mit einer optischen oder akustischen Messeinrichtung (27, 227, 327) mit Sender (24, 324) und Empfänger (26, 326), welche in dem Rahmen angeordnet sind, wobei die Messeinrichtung (27, 227, 327) dazu ausgebildet ist mit entsprechender Entfernungsmessung über einen reflektierten Strahlenweg einen Abstand eines Fingers (22, 222, 322) einer Bedienperson auf einem Bedien-Feld (20, 220) zu der Messeinrichtung zu ermitteln und beim Auflegen auf das Bedien-Feld dies als Bedienung auszuwerten, wobei der Messeinrichtung zur Entfernungsmessung mehrere in einer Linie liegende Bedien-Felder (20, 220) zugeordnet sind, **dadurch gekennzeichnet, dass** die Bedien-Felder (20, 220) auf einem angrenzenden Bereich der Arbeitsplatte (218) zu dem Kochfeld hin in wenigstens einer Linie angeordnet sind.

2. Anordnung nach Anspruch 1, **dadurch gekennzeichnet, dass** die Linie der Bedien-Felder (20, 220) parallel zu einem Rahmen (16, 216) des Kochfeldes verläuft.

3. Anordnung nach Anspruch 1 oder 2, **dadurch gekennzeichnet, dass** der Abstand der Bedien-Felder zum Rahmen sehr gering ist und wenige cm beträgt.

4. Anordnung nach einem der vorhergehenden Ansprüche, **dadurch gekennzeichnet, dass** die Messeinrichtungen (27, 327) unterhalb des Glaskerarnik-Kochfeldes und im selben Gehäuse wie dieses bzw. wie dessen Funktionseinheiten angeordnet sind.

5. Anordnung nach Anspruch 4, **dadurch gekennzeichnet, dass** die Messeinrichtungen (27, 327) im Bereich nahe des Rahmens (16, 216) des Kochfeldes angeordnet sind, neben dem die Bedien-Felder (20, 220) angeordnet sind.

6. Anordnung nach einem der vorhergehenden Ansprüche, **dadurch gekennzeichnet, dass** die Bedien-Felder (20, 220) dauerhaft und sichtbar an oder auf der Arbeitsplatte gekennzeichnet (18, 218) oder angebracht sind.

7. Anordnung nach Anspruch 6, **dadurch gekennzeichnet, dass** die Bedien-Felder (20, 220) aufgraviert, aufgedruckt oder aufgeklebt sind.

8. Anordnung nach einem der vorhergehenden Ansprüche, **dadurch gekennzeichnet, dass** die Linie mit Abstand zu der Messeinrichtung und daran vorbei verläuft.

9. Anordnung nach Anspruch 8, **dadurch gekennzeichnet, dass** mehrere Messeinrichtungen nebeneinander angeordnet sind und die Linie mit gleichem Abstand bzw. parallel dazu verläuft.

10. Anordnung nach Anspruch 8 oder 9, **dadurch gekennzeichnet, dass** so viele Messeinrichtungen vorgesehen sind, wie Bedien-Felder entlang einer einzigen Linie vorhanden sind.

11. Anordnung nach Anspruch 10, **dadurch gekennzeichnet, dass** die Bedien-Felder mit gleichem Abstand dazu angeordnet sind.

12. Anordnung nach Anspruch 10 oder 11, **dadurch gekennzeichnet, dass** die Bedien-Felder genau gegenüber einer Messeinrichtung angeordnet sind.

13. Anordnung nach einem der vorhergehenden Ansprüche, **dadurch gekennzeichnet, dass** mehrere Bedien-Felder (20) in zwei oder mehr parallelen Linien zueinander vorgesehen sind.

14. Anordnung nach einem der vorhergehenden Ansprüche, **dadurch gekennzeichnet, dass** der Reflex-Lichtstrahlenweg parallel zur Fläche der Bedien-Felder (20, 220) verläuft.

15. Anordnung nach einem der vorhergehenden Ansprüche, **gekennzeichnet durch** Beleuchtungsmittel (21b), welche ein Bedien-Feld (20, 220) **durch** Beleuchtung oder einen Lichtpunkt kennzeichnen.

16. Anordnung nach einem der vorhergehenden Ansprüche, **dadurch gekennzeichnet, dass** Sender (24, 324) und Empfänger (26, 326) innerhalb oder unterhalb des Randes (16, 35, 216) angeordnet sind.

17. Anordnung nach Anspruch 16, **dadurch gekennzeichnet, dass** Sender (24, 324) und Empfänger (26, 326) innerhalb oder unterhalb des Randes (16, 35, 216) angeordnet sind mit Lichtleitern (28) oder Lichtumlenkmitteln nach außen zu den Bedien-Feldern (20).

18. Anordnung nach Anspruch 17, **dadurch gekennzeichnet, dass** eine Richtungsänderung des Lichtweges vorgesehen ist.

## Claims

1. Arrangement comprising a worktop and a glass-ceramic hob which is arranged in the worktop and has a frame (16, 216), wherein an operating control device (20, 220) is provided, having an optical or acoustic measuring device (27, 227, 327) having a transmitter (24, 324) and receiver (26, 326) which are arranged in the frame, wherein the measuring device (27, 227, 327) is designed to determine a distance of a finger (22, 222, 322) of an operator on a control panel (20, 220) from the measuring device by way of corresponding distance measurement over a reflected beam path and, when said finger is placed on the control panel, to evaluate this as operation, wherein the measuring device for distance measurement has a plurality of associated control panels (20, 220) which are situated in a line, **characterized in that** the control panels (20, 220) are arranged on an adjoining region of the worktop (218) with respect to the hob in at least one line.

2. Arrangement according to Claim 1, **characterized in that** the line of control panels (20, 220) runs parallel to a frame (16, 216) of the hob.

3. Arrangement according to Claim 1 or 2, **characterized in that** the distance between the control panels and the frame is very small and amounts to a few centimetres.

4. Arrangement according to one of the preceding claims, **characterized in that** the measuring devices (27, 327) are arranged beneath the glass-ceramic hob and in the same housing as the said glass-ceramic hob or as the functional units of the said glass-ceramic hob.

5. Arrangement according to Claim 4, **characterized in that** the measuring devices (27, 327) are arranged in the region close to the frame (16, 216) of the hob next to which the control panels (20, 220) are arranged.

6. Arrangement according to one of the preceding claims, **characterized in that** the control panels (20, 220) are permanently and visibly identified (18, 218) at or on or fitted to or on the worktop.

7. Arrangement according to Claim 6, **characterized in that** the control panels (20, 220) are engraved, printed or adhesively bonded.

8. Arrangement according to one of the preceding claims, **characterized in that** the line runs at a distance from the measuring device and past it.

9. Arrangement according to Claim 8, **characterized in that** a plurality of measuring devices are arranged next to one another and the line runs at the same distance and parallel thereto.

10. Arrangement according to Claim 8 or 9, **characterized in that** the number of measuring devices provided is equal to the number of control panels present along a single line.

11. Arrangement according to Claim 10, **characterized in that** the control panels are arranged at the same distance therefrom.

12. Arrangement according to Claim 10 or 11, **characterized in that** the control panels are arranged exactly opposite a measuring device.

13. Arrangement according to one of the preceding claims, **characterized in that** a plurality of control panels (20) are provided in two or more parallel lines in relation to one another.

14. Arrangement according to one of the preceding claims, **characterized in that** the reflected-light beam path runs parallel to the surface of the control panels (20, 220).

15. Arrangement according to one of the preceding claims, **characterized by** illumination means (21b) which identify a control panel (20, 220) by illumination or a light point.

16. Arrangement according to one of the preceding claims, **characterized in that** transmitters (24, 324) and receivers (26, 326) are arranged inside or beneath the border (16, 35, 216).

17. Arrangement according to Claim 16, **characterized in that** transmitters (24, 324) and receivers (26, 326) are arranged inside or beneath the border (16, 35, 216) with light guides (28) or light deflection means towards the outside to the control panels (20).

18. Arrangement according to Claim 17, **characterized in that** a change in direction for the light path is provided.

## Revendications

1. Arrangement comprenant un plan de travail et une plaque en vitrocéramique arrangée dans le plan de travail avec un cadre (16, 216), un dispositif de commande (20, 220) étant prévu avec un dispositif de mesure (27, 227, 327) optique ou acoustique pourvu d'un émetteur (24, 324) et d'un récepteur (26, 326) disposés dans le cadre, le dispositif de mesure (27, 227, 327) étant réalisé pour calculer une distance d'un doigt (22, 222, 322) d'un utilisateur sur un champ de commande (20, 220) par rapport au dispositif de mesure à l'aide de la mesure d'éloignement correspondante par le biais d'une trajectoire de rayons réfléchis et pour l'utiliser comme commande lors de la mise en contact avec le champ de commande, plusieurs champs de commande (20, 220) alignés étant associés au dispositif de mesure pour réaliser la mesure d'éloignement, **caractérisé en ce que** les champs de commande (20, 220) sont disposés le long d'au moins une ligne sur une zone connexe du plan de travail (218) en direction du plan de cuisson.

2. Arrangement selon la revendication 1, **caractérisé en ce que** la ligne des champs de commande (20, 220) s'étend parallèlement à un cadre (16, 216) du plan de cuisson.

3. Arrangement selon la revendication 1 ou 2, **caractérisé en ce que** la distance des champs de commande par rapport au cadre est très réduite et est de l'ordre de quelques cm.

4. Arrangement selon l'une quelconque des revendications précédentes, **caractérisé en ce que** les dispositifs de mesure (27, 327) sont disposés en dessous de la plaque en vitrocéramique et dans la même coque qu'elle et/ou que ses unités fonctionnelles.

5. Arrangement selon la revendication 4, **caractérisé en ce que** les dispositifs de mesure (27, 327) sont disposés dans la zone située à proximité du cadre (16, 216) du plan de cuisson à côté de laquelle sont disposés les champs de commande (20, 220).

6. Arrangement selon l'une quelconque des revendications précédentes, **caractérisé en ce que** les champs de commande (20, 220) sont indiqués ou disposés de façon durable et visible contre ou sur le plan de travail (18, 218).

7. Arrangement selon la revendication 6, **caractérisé en ce que** les champs de commande (20, 220) sont gravés, imprimés ou collés en surface.

8. Arrangement selon l'une quelconque des revendications précédentes, **caractérisé en ce que** la ligne s'étend à une certaine distance du dispositif de mesure et le long de celui-ci.

9. Arrangement selon la revendication 8, **caractérisé en ce que** plusieurs dispositifs de mesure sont disposés côte à côte et que la ligne s'étend à même distance et/ou parallèlement à ceux-ci.

10. Arrangement selon la revendication 8 ou 9, **caractérisé en ce qu'**il y a autant de dispositifs de mesure prévus que de champs de commande placés le long d'une ligne unique.

11. Arrangement selon la revendication 10, **caractérisé en ce que** les champs de commande sont placés à même distance relative.

12. Arrangement selon la revendication 10 ou 11, **caractérisé en ce que** les champs de commande sont disposés précisément en face d'un dispositif de mesure.

13. Arrangement selon l'une quelconque des revendications précédentes, **caractérisé en ce que** plusieurs champs de commande (20) sont prévus de façon à être placés les uns par rapport aux autres sur deux lignes parallèles ou plus.

14. Arrangement selon l'une quelconque des revendications précédentes, **caractérisé en ce que** la course de faisceau lumineux réfléchissant s'étend parallèlement à la surface des champs de commande (20, 220).

15. Arrangement selon l'une quelconque des revendications précédentes, **caractérisé par** la présence de moyens d'éclairage (21b) indiquant un champ de commande (20, 220) par un éclairage ou un point lumineux.

16. Arrangement selon l'une quelconque des revendications précédentes, **caractérisé en ce que** les émetteurs (24, 324) et les récepteurs (26, 326) sont disposés à l'intérieur ou en dessous de la bordure (16, 35, 216).

17. Arrangement selon la revendication 16, **caractérisé en ce que** les émetteurs (24, 324) et les récepteurs (26, 326) sont disposés à l'intérieur ou en dessous de la bordure (16, 35, 216), avec des conducteurs lumineux (28) ou des moyens de déviation de la lumière s'étendant vers l'extérieur par rapport aux champs de commande (20).

18. Arrangement selon la revendication 17, **caractérisé en ce qu'**un changement de direction de la trajectoire de la lumière est prévu.
